Europäisches Patentamt

European Patent Office

Office européen des brevets

(19)

(11) **EP 1 416 328 A2**

(12) **EUROPEAN PATENT APPLICATION**

(43) Date of publication:
**06.05.2004 Bulletin 2004/19**

(51) Int Cl.$^7$: **G03F 7/20**

(21) Application number: **03256892.5**

(22) Date of filing: **30.10.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **01.11.2002 EP 02257609**

(71) Applicant: **ASML Netherlands B.V.**
**5503 LA Veldhoven (NL)**

(72) Inventors:
- **Den Boef, Arie Jeffrey**
  **5581 AB Waalre (NL)**

- **Van der Laan, Hans**
  **5501 CL Veldhoven (NL)**
- **Van Dijsseldonk, Antonius Johannes Josephus**
  **5527 BH Hapert (NL)**
- **Dusa, Mircea**
  **Campbell, California 95008-5134 (US)**
- **Kiers, Antoine Gaston Marie**
  **5501 DW Veldhoven (NL)**

(74) Representative: **Leeming, John Gerard**
**J.A. Kemp & Co.,**
**14 South Square,**
**Gray's Inn**
**London WC1R 5JJ (GB)**

(54) **Inspection method and device manufacturing method**

(57) Aberrations in a lithographic apparatus are detected by printing a test pattern having at least one degree of symmetry and that is sensitive to a particular aberration in the apparatus and using a scatterometer to derive information concerning the aberration. The test structure may comprise a two-bar grating, in which case the inner and outer duty ratios can be reconstructed to derive information indicative of comatic aberration. Alternatively, a hexagonal array of dots can be used, in which case the scatterometry data can be used to reconstruct the dot diameters which are indicative of 3-wave aberration.

## Fig. 4

**Description**

The present invention methods of inspection useable in the manufacture of devices by lithographic techniques and to methods of manufacturing devices using lithographic techniques.

In a manufacturing process using a lithographic projection apparatus, a pattern (e.g: in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

The measurement and inspection step after development of the resist, referred to as in-line because it is carried out in the normal course of processing production wafers, serves two purposes. Firstly, it is desirable to detect any target areas where the pattern in the developed resist is faulty. If a sufficient number of dies are faulty, the wafer can be stripped of the patterned resist and re-exposed, hopefully correctly, rather than making the fault permanent by carrying out a process step, e.g. an etch, with a faulty pattern. Secondly, the measurements may allow errors in the lithographic apparatus, e.g. illumination settings or exposure times, to be detected and corrected for subsequent exposures. However, many errors in the lithographic apparatus cannot easily be detected or quantified from the patterns printed in exposures. Detection of a fault does not always lead directly to its cause. Thus, a variety of off-line procedures for detecting and measuring errors in the lithographic apparatus are known. These may involve replacing the substrate with a measuring device or carrying out exposures of special test patterns, e.g. at a variety of different machine settings. Such off-line techniques take time, often a considerable amount, during which the apparatus cannot be used for production exposures. Therefore, in-line techniques, ones which can be carried out using or at the same time as production exposures, for detecting and measuring errors in the lithographic apparatus are preferred.

One in-line technique used in device manufacturing for measurements of linewidth, pitch and critical dimension (CD) is known as "scatterometry". Methods of scatterometry are described in Raymond *et al* "Multiparameter Grating Metrology Using Optical Scatterometry", J. Vac. Sci. Tech. B, Vol.15 no.2 361-368 1997 and Niu *et al* "Specular Spectroscopic Scatterometry in DUV Lithography", SPIE, Vol. 3677, 1999. In scatterometry, white light is reflected by periodic structures in the developed resist and the resulting reflection spectrum at a given angle detected. The structure giving rise to the reflection spectrum is reconstructed, e.g. using Rigorous Coupled-Wave Analysis (RCWA) or by comparison to a library of patterns derived by simulation.

Pattern asymmetry is an error that can have a number of sources in the lithographic apparatus, including aberrations in the projection system, non-aberration projection lens artifacts, the reticle and the resist processing. Existing techniques for measuring pattern asymmetry are difficult, off-line and do not directly measure the effects in resist so that it is not guaranteed that measures taken to minimize the problem will have the desired effect in the finished product.

It is an object of the present invention to provide an in-line method of measuring pattern asymmetry during manufacture of devices using lithographic techniques.

This and other objects are achieved according to the invention in an inspection method comprising the steps of:

using a lithographic apparatus to print onto a substrate a test pattern having at least one degree of symmetry, said pattern being sensitive to at least one type of aberration that may be present in said lithographic apparatus; using a scatterometer to measure a reflection spectrum of said test pattern; and deriving from the reflection spectrum information indicative of the amount of said at least one type of aberration present in said lithographic apparatus.

By this method, a rapid measurement of aberration in the lithographic apparatus can be obtained. The test pattern can be printed in the course of production exposures, for example in a scribe lane or edge die or other unused area of the substrate, without requiring significant additional time. The reflection spectrum can be measured by the scatterometer equally quickly and without delaying the production line. The measurement method of the invention can therefore be used in-line, as a qualification or calibration tool. If the lithographic apparatus is provided with suitable controls, e.g. adjustable elements in the projection lens, an immediate correction can be applied to improve imaging of subsequent wafers. Alternatively if the measured aberration is sufficiently severe, the lithographic apparatus can be taken out of production for corrective maintenance straight away, before large numbers of defective wafers are produced.

Preferably the scatterometry step is carried out on the pattern in developed resist although if there is sufficient contrast in the latent resist image, the scatterometry step may be carried out before development. Because the aberration is detected before a process step is carried out, if the aberration is severe enough to result in a defective device, the resist can be stripped and the substrate put back into the process for re-imaging.

In a preferred method of the invention, the test pattern comprises a two-bar grating and the reflectance spectrum measured by the scatterometer is used to reconstruct the grating with the inner and outer duty ratios as parameters. Deviations in the reconstructed duty ratios from the expected values are indicative of comatic aberration in the lithographic apparatus.

In another preferred method, the test pattern comprises a hexagonal array of dots and the reflectance spectrum measured by the scatterometer is used to reconstruct the diameters of the spots. Differences in the diameters of the first, third and fifth dots in each unit cell compared to the second, fourth and sixth dots, are indicative of 3-wave aberrations.

Of course, other test patterns sensitive to other aberrations may be used and multiple test patterns of the same or different types may printed on the same substrate.

In a further preferred method, the test pattern comprises first, second and third structures of the same basic form, said first and second structures having equal, but opposite, asymmetric deviations from said basic form and said third structure having an additional asymmetric deviation as compared to said second structure. Further structures may also be used and the results averaged to reduce noise. First, second and third reflection spectra are then obtained from the respective structures and the information indicative of the amount of aberration is derived by dividing the difference between the first and second scatterometry signals by the difference between the third and second scatterometry signals. By this method, information about the aberration in the lithographic apparatus can be obtained without needing to reconstruct the structure from the scatterometry signal, which is computationally intensive and not always numerically robust.

The further preferred method can be applied to measure comatic aberration using a test pattern in which the first, second and third structures are two-bar gratings, the first structure has bar widths $W_1$ and $W_2$, where $W_1 > W_2$, the second structure is a mirror image of the first structure and the third structure has bar widths $W_2 + d$ and $W_1 - d$, where $d < (W_1 - W_2)$.

Preferably, the scatterometry step(s) is (are) carried out using normal incidence, white light scatterometry.

According to a further aspect of the invention there is provided a device manufacturing method comprising the steps of:

  providing a substrate that is at least partially covered by a layer of radiation-sensitive material;
  providing a projection beam of radiation using a radiation system;
  using patterning means to endow the projection beam with a pattern in its cross-section;
  projecting the patterned beam of radiation onto a target portion of the layer of radiation-sensitive material,

characterized in that:

  said pattern comprises a pattern representing a process layer and a test pattern having at least one degree of symmetry, said test pattern being sensitive to at least one other type of aberration that may be present in said lithographic apparatus; and by the further steps of:

  using a scatterometer to measure the reflection spectrum of said test pattern; and
  deriving from the reflection spectrum information indicative of the amount of said at least one type of aberration present in said lithographic apparatus.

Preferably, the test pattern is printed in an area adjacent the pattern of the production layer, such as a scribe lane. In this way, no unnecessary space is taken up on the substrate and a maximum area remains for production of devices.

In a preferred embodiment of this aspect of the invention, said information indicative of the amount of said at least one type of aberration is used to adjust a parameter of the lithographic apparatus after which a further substrate is provided and said steps of providing a projection beam, using patterning means and projecting the patterned beam, are repeated.

In this way, the results of scatterometry measurements taken on one substrate can be used to adjust the lithographic apparatus so that subsequent exposures are improved.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system; including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Embodiments of the invention will now be described, by way of example only, with reference to the accompanying schematic drawings in which:

Figure 1 depicts a lithographic projection apparatus that may be used to perform methods according to the invention;
Figure 2 is a flow diagram of a lithographic process according to an embodiment of the invention;
Figure 3 depicts a scatterometer useable in methods according to the present invention;
Figure 4 depicts a grating pattern used in a first method according to the present invention;
Figure 5 depicts a grating pattern used in a second embodiment of the present invention; and
Figure 6 depicts three grating patterns used in a third method according to the present invention.

In the Figures, corresponding reference symbols indicate corresponding parts.

Lithographic Projection Apparatus

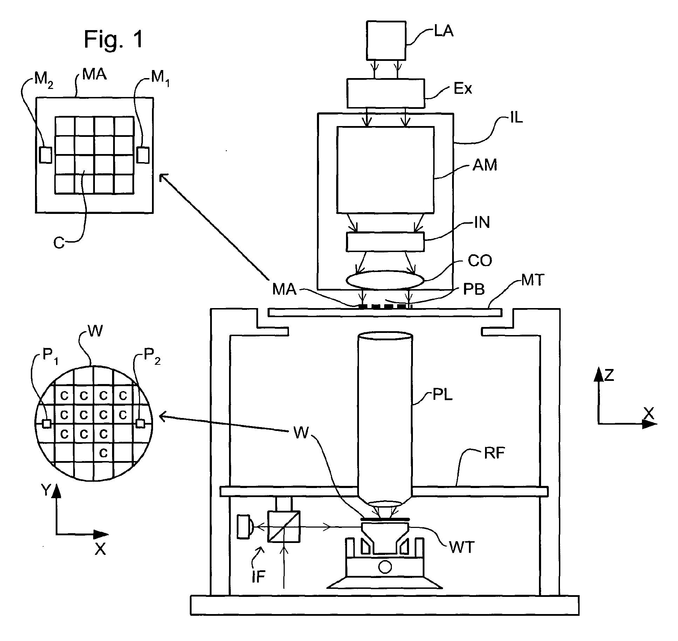

Figure 1 schematically depicts a lithographic projection apparatus useable in methods according to the invention. The apparatus comprises:

a radiation system Ex, IL, for supplying a projection beam PB of radiation (e.g. DUV radiation), which in this particular case also comprises a radiation source LA;

a first object table (mask table) MT provided with a mask holder for holding a mask MA (e.g. a reticle), and connected to first positioning means for accurately positioning the mask with respect to item PL;

a second object table (substrate table) WT provided with a substrate holder for holding a substrate W (e.g. a resist-coated silicon wafer), and connected to second positioning means for accurately positioning the substrate with respect to item PL;

a projection system ("lens") PL (e.g. a refractive lens system) for imaging an irradiated portion of the mask MA onto a target portion C (*e.g.* comprising one or more dies) of the substrate W.

As here depicted, the apparatus is of a transmissive type (*e.g.* has a transmissive mask). However, in general, it may also be of a reflective type, for example (*e.g.* with a reflective mask). Alternatively, the apparatus may employ another kind of patterning means, such as a programmable mirror array of a type as referred to above.

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (*e.g.* with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in the following preferred modes:

1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.

3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

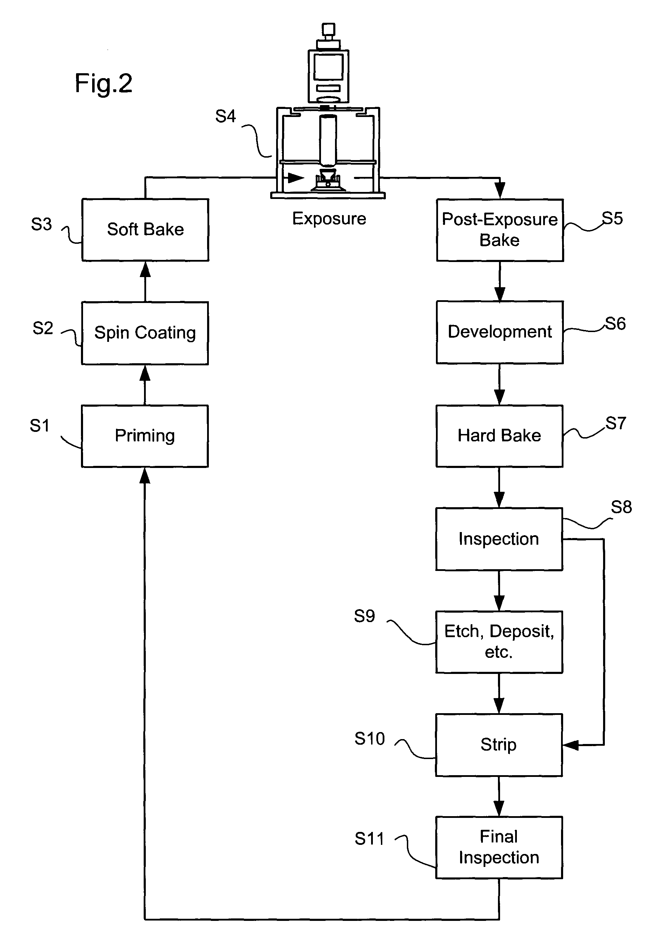

Figure 2 is a flow diagram of a lithographic process of which the present invention may form part. Prior to the exposure step S4, which may be carried out using a lithographic apparatus such as described above with relation to Figure 1, a substrate, *e.g.* a silicon wafer, undergoes a priming step S1, spin coating step S2 to coat it with a layer of resist and a soft bake S3 to remove solvents from the resist. After exposure; the wafer undergoes a post-exposure bake S5, a development step S6 during which the exposed or unexposed resist (depending on whether the resist is positive or negative) is removed and a hard bake S7, prior to an inspection step S8. The inspection step S8 includes various different measurements and inspections and according to the invention includes a scatterometry step described further below. If the wafer passes inspection, a process step S9 is carried out. This may involve etching the areas of the substrate not covered by resist, deposition of a product layer, metallization, ion implantation, etc. After the process step S9 the remaining resist is stripped S10 and a final inspection S11 carried out before the process resumes for another layer. In case a substrate fails an inspection at S8, it may be directed directly to a stripping step S10 and another attempt to print the same process layer made.

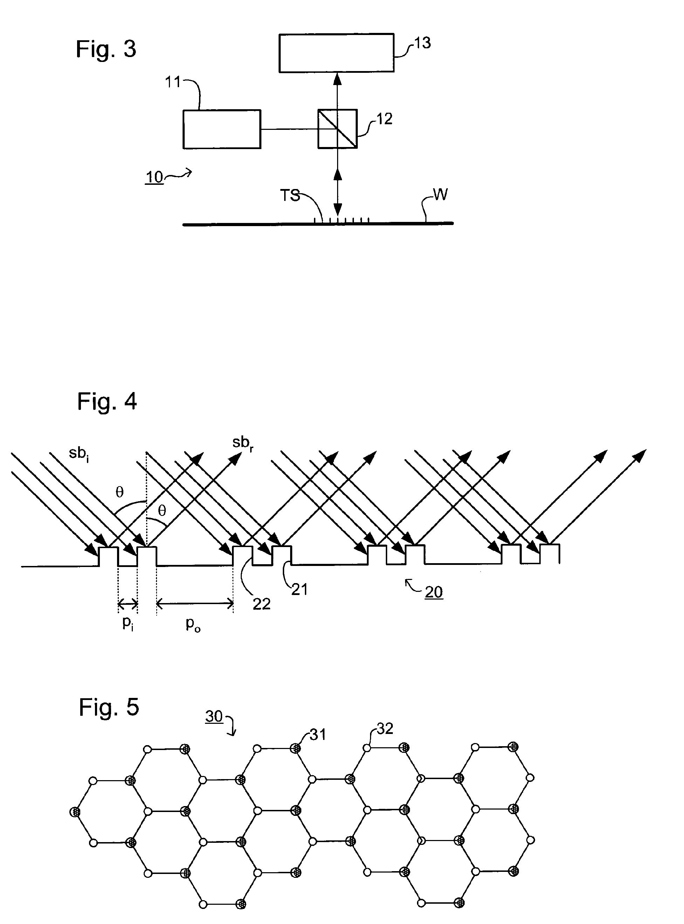

In the inspection step S8, a scatterometer such as depicted in Figure 3 may be used. The scatterometer 10 comprises a broadband (white light) radiation source 11 which directs radiation via a beamsplitter 12 onto a test structure TS on the wafer W. The reflected radiation is passed to a spectrometer 13 which measures a spectrum (intensity as a function of wavelength) of the specular reflected radiation. From this data, the structure giving rise to the detected spectrum may be reconstructed, *e.g.* by Rigorous Coupled Wave Analysis and non-linear regression or by comparison with a library of simulated spectra. In general, for the reconstruction the general form of the structure is known and some parameters are assumed from knowledge of the process by which the structure was made, leaving only a few parameters of the structure to be determined from the scatterometry data.

As illustrated, the scatterometer is a normal-incidence scatterometer.. However the same principle may be applied using inclined incidence scatterometry. Variants of scatterometry in which the reflection at a range of angles of a single wavelength, rather than the reflection at a single angle of a range of wavelengths, is measured may also be used.

Embodiment 1

According to a first method of the invention, the test structure printed on the substrate W comprises a repeating two-bar grating as depicted in Figure 4. The grating 20 comprises a pair of bars 21, 22 repeated a large number of times. The grating is printed such that after development, the bars are formed of solid resist lines. This pattern is sensitive to comatic aberrations in the lithographic projection apparatus, particularly the projection system PL, and illumination asymmetry and the presence of such aberrations will manifest themselves in a variation in the printed grating of the inner and outer duty ratios $P_i$, $P_o$ from their intended values. Accordingly, the scatterometry data of the printed grating 20 is used to reconstruct the grating with the duty ratios $P_i$, $P_o$ as parameters of the reconstruction process. The other parameters of the grating, such as linewidths and shapes, may be input to the reconstruction process from knowledge of the printing step and/or other scatterometry processes.

Embodiment 2

A grating structure used in a second method of the present invention is depicted in Figure 5. This grating structure is a two-dimensional grating with a hexagonal unit cell with a dot at each corner of the unit cell. This pattern is sensitive to three-wave aberration which will cause the diameter of the black dots 31 to change relative to the white dots 32. The ratio of the diameters of the black dots to the white dots can be recovered from the scatterometry data.

Embodiment 3

In a third method according to the present invention, three test grating structures are used to measure comatic aberrations without the need to reconstruct the grating structures which is computationally intensive and not always possible if the number and thickness of the underlying layers is not known.

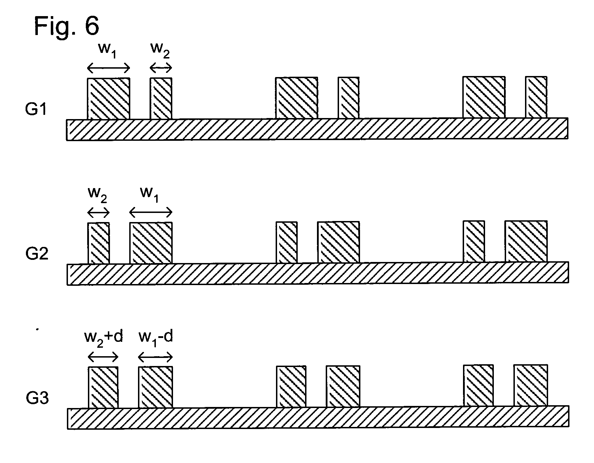

Figure 6 depicts the three gratings G1, G2 and G3 which are used in one example of this method of the present invention.

As depicted in Figure 6, gratings G1, G2 and G3 each comprise repeating two-bar structures. Gratings G1 and G2 are mirror symmetric with bars of width $w_1$ and $w_2$. Compared to a two-bar structure with equal line widths, G1 and G2 have equal, but opposite asymmetries. If these gratings are printed perfectly, with no comatic aberration, then using a normal incidence scatterometer the two gratings will generate identical scatterometry signals $S_1$ and $S_2$ because they are mirror symmetric. Thus, with no comatic aberration we have:

$$S_1 - S_2 = 0 \tag{1}$$

If however a small amount of comatic aberration is present, the ideal linewidths $w_1$ and $w_2$ will change in opposite directions by an amount $\Delta w$ giving:

$$w_1' = w_1 + \Delta w$$

$$w_2' = w_2 - \Delta w \tag{2}$$

Assuming that the scatterometry signal is linear for small aberrations, the difference between the two scatterometry signals will then be given by:

$$S_1 - S_2 = 2\frac{dS}{dw} \times \Delta w \tag{3}$$

The derivative dS/dw is measured using the third grating G3 which is similar to the second grating G2 but has an additional small asymmetry $d$ in the linewidth. Comparing the scatterometry $S_3$ from grating G3 with $S_2$ from grating G2 yields:

$$\frac{dS}{dw} = \frac{(S_3 - S_2)}{d} \tag{4}$$

Substituting into equation (3), yields the linewidth change $\Delta w$ caused by comatic aberration:

$$\Delta w = \left( \frac{S_1 - S_2}{S_3 - S_2} \right) \times \frac{d}{2} \tag{5}$$

The values $S_1$, $S_2$ and $S_3$ can be taken directly from the scatterometry data for a variety of wavelengths to enable simple calculation of the error introduced by any comatic aberration. In the event that the scatterometer response is not linear, this can be accounted for by additional gratings similar to G3 but with different values of $d$.
This technique can also be applied to the hexagon array used to measure 3-wave aberrations.
Whilst specific embodiments of the invention have been described above, it will be appreciated that the invention may be practiced otherwise than as described. The description is not intended to limit the invention.

**Claims**

**1.** An inspection method comprising the steps of:

using a lithographic apparatus to print onto a substrate a test pattern having at least one degree of symmetry, said pattern being sensitive to at least one type of aberration that may be present in said lithographic apparatus;
using a scatterometer to measure a reflection spectrum of said test pattern; and
deriving from the reflection spectrum information indicative of the amount of said at least one type of aberration present in said lithographic apparatus.

**2.** An inspection method according to claim 1 wherein said test pattern comprises a two-bar grating.

**3.** An inspection method according to claim 2 wherein said step of deriving information comprises reconstructing the two-bar grating with the inner and outer duty ratios as parameters so as to derive information indicative of comatic aberration in the lithographic apparatus.

4. An inspection method according to claim 1, 2 or 3, wherein the test pattern comprises a hexagonal array of dots.

5. An inspection method according to claim 4 wherein said step of deriving information comprises reconstructing the diameters of the spots, differences in the diameters of spots in each unit cell of the array being indicative of 3-wave aberrations in the lithographic apparatus.

6. An inspection method according to claim 1 wherein said test pattern comprises first, second and third structures of the same basic symmetric form, said first and second structures having equal but opposite asymmetric deviations from said basic symmetric form and said third structure having an additional asymmetric deviation as compared to said second structure.

7. An inspection method according to claim 6 wherein said step of deriving information comprises dividing the difference between scatterometry signals obtained from said first and second structures by the difference between scatterometry signals obtained from said third and second structures.

8. An inspection method according to claim 7 or 8, wherein said first, second and third structures are two-bar gratings, the first structure having bar widths $w_1$ and $w_2$ where $w_1$ is greater than $w_2$, the second structure being a mirror image of the first structure, and the third structure having bar widths $w_2+d$ and $w_1-d$ where d is less than $w_1-w_2$.

9. An inspection method according to any one of the preceding claims wherein said scatterometer is a normal incidence scatterometer.

10. A device manufacturing method comprising the steps of:

   providing a substrate that is at least partially covered by a layer of radiation-sensitive material;
   providing a projection beam of radiation using a radiation system;
   using patterning means to endow the projection beam with a pattern in its cross-section;
   projecting the patterned beam of radiation onto a target portion of the layer of radiation-sensitive material,

   **characterized in that**:

   said pattern comprises a pattern representing a process layer and a test pattern having at least one degree of symmetry, said test pattern being sensitive to at least one other type of aberration that may be present in said lithographic apparatus; and by the further steps of:

   using a scatterometer to measure the reflection spectrum of said test pattern; and
   deriving from the reflection spectrum information indicative of the amount of said at least one type of aberration present in said lithographic apparatus.

## Fig. 1

Fig.2

| | | |
|---|---|---|
| S4 | Exposure | |
| S3 — Soft Bake | | S5 — Post-Exposure Bake |
| S2 — Spin Coating | | S6 — Development |
| S1 — Priming | | S7 — Hard Bake |
| | | S8 — Inspection |
| | | S9 — Etch, Deposit, etc. |
| | | S10 — Strip |
| | | S11 — Final Inspection |

Fig. 3

Fig. 4

Fig. 5

## Fig. 6